Europäisches Patentamt

European Patent Office

Office européen des brevets

(19)

(11) Veröffentlichungsnummer: **0 200 027**
**A2**

(12) **EUROPÄISCHE PATENTANMELDUNG**

(21) Anmeldenummer: **86104614.2**

(22) Anmeldetag: **04.04.86**

(51) Int. Cl.⁴: **G 01 N 24/14**
**H 01 J 49/38**

(30) Priorität: **02.05.85 DE 3515766**

(43) Veröffentlichungstag der Anmeldung:
**05.11.86 Patentblatt 86/45**

(84) Benannte Vertragsstaaten:
**CH DE FR GB LI**

(71) Anmelder: **Spectrospin AG**
**Industriestrasse 26**
**CH-8117 Zürich-Fällanden(CH)**

(72) Erfinder: **Kellerhals, Hanspeter**
**Hegetsbergstrasse 6**
**CH-8610 Uster(CH)**

(72) Erfinder: **Kofel, Peter**
**Burstwiesenstrasse 14**
**CH-8606 Greifensee(CH)**

(74) Vertreter: **Patentanwälte Kohler - Schwindling - Späth**
**Hohentwielstrasse 41**
**D-7000 Stuttgart 1(DE)**

(54) **Ionen-Zyklotron-Resonanz-Spektrometer.**

(57) Bei einem Ionen-Zyklotron-Resonanz-Spektrometer werden die Ionen außerhalb der Ionenfalle (8) in einer besonderen Ionenquelle (5, 6) erzeugt und der Ionenfalle in Form eines Ionenstrahles (14) zugeführt. Dabei wird entweder zum Abbremsen der Ionen der Gasdruck innerhalb der Ionenfalle (8) erhöht, so daß den Ionen durch Stoßvorgänge innerhalb der Ionenfalle (8) Energie entzogen wird, oder aber es wird das Fangpotential an der Ionenfalle abgeschaltet, so daß die Ionen vor der Ionenfalle so stark abgebremst werden können, daß sie innerhalb der Ionenfalle zum Stillstand kommen. Die auf diese Weise innerhalb der Ionenfalle (8) angesammelten Ionen können dann durch Einschalten der Fangpotentiale gefangen werden.

Fig. 1

/1.

Anmelderin:

Firma
Spectrospin AG
Industriestraße 26
CH 8117 Fällanden/Zürich
Schweiz

Stuttgart, den 11.4.1985
P 4622 EP


Vertreter:

Kohler-Schwindling-Späth
Patentanwälte
Hohentwielstraße 41
7000 Stuttgart 1

## Ionen-Zyklotron-Resonanz-Spektrometer

Die Erfindung betrifft ein Ionen-Zyklotron-Resonanz-Spektrometer mit einer Ionenfalle, die als Elektroden ausgebildete Wände aufweist, an denen die Ionen in der Falle haltende elektrische Fangpotentiale anliegen, und in der ein homogenes, konstantes Magnetfeld herrscht, und mit einer Einrichtung zum Einbringen von Ionen in die Ionenfalle, die eine Ionenquelle und Mittel zum Erzeugen und Führen eines von der Ionenquelle ausgehenden Ionenstrahles umfaßt.

2   0200027

Der Aufbau eines Ionen-Zyklotron-Resonanz- oder ICR-Spektromters ist beispielsweise in der DE-OS 33 31 136 beschrieben. Bei solchen Spektrometern besteht ein Problem darin, Moleküle der zu untersuchenden Substanz innerhalb der Meßzelle zu ionisieren, ohne daß die für diesen Prozeß notwendigen Einrichtungen die anschließende Massenbestimmung stören. Man will ja nicht nur Moleküle von reinen Substanzen studieren, welche einen genügend hohen Dampfdruck aufweisen, so daß sie nach Einbringen der Substanz in das Vakuumsystem in genügender Anzahl gasförmig vorliegen und durch einfachen Elektronenstoß oder chemische Ionisation ionisiert werden können. Vielmehr möchte man auch die Klasse der schwerflüchtigen Substanzen untersuchen und muß zu diesem Zweck die Möglichkeit haben, andere Ionisierungsverfahren wie z.B. "Fast Atom Bombardment" und "Field Desorption" einzusetzen. Zudem möchte man Substanzgemische untersuchen und den zur Vortrennung nötigen Chromatographen direkt mit dem ICR-Meßsystem koppeln. Allen diesen Forderungen gemeinsam ist, daß ihre Realisierung direkt in bzw. an der Meßzelle das Erreichen tiefer Drucke erschwert oder verunmöglicht, so daß die Massenbestimmung mit ICR nur noch mit reduzierter Auflösung durchgeführt werden kann. Das direkte Einbringen der Substanz in die Meßzelle hat zudem den Nachteil, daß nach einer Messung Substanzspuren zurückbleiben können, welche eine neue, nachfolgende Messung stören. Zudem wäre es wünschenswert, ein System zur Ionisierung und zur Überführung der Ionen zu verwirklichen, das eine Vorselektion der Ionen erlaubt, um die dem ICR-Meßverfahren inhärenten Dynamikprobleme zu eliminieren oder zu verringern.

Es ist auch schon im Juni 1984 in einer Konferenz der Gedanke geäußert worden, die Ionen nicht innerhalb der Ionenfalle durch Bestrahlen mit Elektronen oder durch Primärionen zu erzeugen, sondern eine außerhalb der Ionenfalle angeordnete Ionenquelle vorzusehen und die dort unter günstigen Bedingungen erzeugten Ionen in Form eines Ionenstrahles in die Ionenfalle einzubringen. Der Verwirklichung dieses Gedankens steht allerdings das Problem entgegen, daß die Ionen eine ausreichend große Energie haben müssen, um die an der Ionenfalle anliegenden Fangpotentiale zu überwinden, und daß bei den bei der Ionen-Zyklotron-Resonanz-Spektrometrie üblichen Drücken die freie Weglänge der Teilchen sehr viel größer ist als die Dimensionen der Zelle, so daß die in die Ionenfalle eindringenden Ionen auch stets eine ausreichend große Energie besitzen, um die Falle wieder zu verlassen. Eine Möglichkeit, diese Schwierigkeit zu überwinden, scheint nur darin zu bestehen, die Ionen auf einer quer zum statischen Magnetfeld gerichteten und daher gekrümmten Bahn zu führen, so daß die Ionen beim Eintritt in die Meßzelle auf die auf das Innere der Meßzelle beschränkte Zyklotron-Bahn gelangen. Hierbei wären jedoch sehr kritische Bedingungen einzuhalten, welche die Durchführung eines solchen Verfahrens nicht praktikabel erscheinen lassen. Daran mag es auch liegen, daß bisher keine Ionen-Zyklotron-Resonanz-Spektrometer bekannt geworden sind, bei denen tatsächlich die Ionen in die Meßzelle in Form eines von einer Ionenquelle ausgehenden Ionenstrahles eingebracht worden wären. Zwar gibt es einen Vorschlag von McIver et al in Int. J. Mass Spectrom. Ion Phys., 64 (1985), S. 67-77, die Ionen mit einer relativ komplizierten, zwei Quadrupole umfassenden Anordnung zu führen, jedoch bleibt auch bei diesem Vorschlag unklar, wie es gelingen soll, die Ionen in der ICR-Zelle einzufangen.

4    0200027

Demgemäß liegt der Erfindung die Aufgabe zugrunde, einen Aufbau eines Ionen-Zyklotron-Resonanz-Spektrometers anzugeben, der das Einbringen von Ionen in die Ionenfalle in Form eines von einer Ionenquelle ausgehenden Ionenstrahles auf einfache Weise ermöglicht.

Diese Aufgabe wird nach der Erfindung dadurch gelöst, daß die Mittel zum Führen des Ionenstrahles in Richtung des Magnetfeldes ausgebildet sind und auf dem Weg des Ionenstrahles eine Einrichtung zum Reduzieren der kinetischen Energie von in die Ionenfalle eindringenden Ionen bis unter den durch die Fangpotentiale bestimmten Wert angeordnet ist, der zum Verlassen der Ionenfalle erforderlich wäre.

Die Erfindung sieht also besondere Mittel vor, um die kinetische Energie der in die Ionenfalle eindringenden Ionen so stark zu reduzieren, daß sie nicht mehr in der Lage sind, die Fangpotentiale zu überwinden, so daß die Ionen gezwungen sind, in der Meßzelle zu verbleiben.

Zum Reduzieren der kinetischen Energie der Ionen gibt es verschiedene Möglichkeiten. Bei einer Ausführungsform der Erfindung umfaßt die Einrichtung zum Reduzieren der kinetischen Energie Mittel zum vorübergehenden Erhöhen und Wiederabsenken des Gasdruckes in der Ionenfalle.

Wird für die Dauer des Einschießens von Ionen der Druck innerhalb der Ionenfalle durch das Einlassen von Gas erhöht, so wird dadurch die mittlere freie Weglänge der Ionen in der Zelle vermindert mit der Folge, daß wenigstens ein Teil der Ionen innerhalb der Falle Energie abgibt und dadurch gefangen wird. Nachdem sich auf diese Weise genügend Ionen in der Ionenfalle angesammelt haben, kann der Gasdruck wieder durch Abpumpen auf den für die Ionen-Zyklotron-Resonanz-Spektrometrie erforderlichen Wert vermindert und dann die Messung durchgeführt werden.

Bei einer anderen Ausführungsform der Erfindung umfaßt die Einrichtung zum Reduzieren der kinetischen Energie wenigstens eine der Ionenfalle vorgeschaltete Bremselektrode, die bewirkt, daß die Ionen bei fehlenden Fangpotentialen gerade die Mitte der Ionenfalle erreichen, sowie eine Einrichtung zum vorübergehenden Aufheben der Fangpotentiale.

Bei dieser Ausführungsform der Erfindung werden also während einer ersten Phase die für das Einschließen der Ionen in der Zelle erforderlichen Potentiale abgeschaltet. Die Ionen des von der Ionenquelle ausgehenden Ionenstrahles werden nach der zur Strahlbildung erforderlichen Beschleunigung wieder abgebremst, und zwar in der Weise, daß die Ionen etwa im Mittelpunkt der Zelle zum Stillstand kommen. Zwar läßt sich diese Bedingung nicht für alle Ionen erfüllen, weil die Ionen neben der aufgezwungenen kinetischen Energie auch thermische Energie besitzen, welche Restgeschwindigkeiten mit stochastischer Verteilung zur Folge hat. Trotzdem läßt sich auf diese Weise im Bereich der Zellenmitte eine relativ hohe Ionenkonzentration erzielen. Danach können in einem zweiten Schritt durch Anlegen der Fangpotentiale die in der Zelle vorhandenen Ionen eingefangen werden, wonach die Aufnahme des Ionen-Zyklotron-Resonanz-Spektrums möglich ist. Dabei ist von besonderem Vorteil, daß es sich bei den in der Meßzelle gefangenen Ionen um solche mit geringer thermischer Energie handelt, also gerade um Ionen, welche für die Messung benötigt werden.

Die Erfindung wird im folgenden anhand der in der Zeichnung dargestellten Ausführungsbeispiele näher beschrieben und erläutert. Die der Beschreibung und der Zeichnung zu entnehmenden Merkmale können bei anderen Ausführungsformen der Erfindung einzeln für sich oder zu mehreren in beliebiger Kombination Anwendung finden. Es zeigen

Fig. 1     eine schematische Darstellung eines Ionen-Zyklotron-Resonanz-Spektrometers nach der Erfindung,

Fig. 2     eine Darstellung des Potentialverlaufes bei der Anordnung nach Fig. 1 mit an der Ionenfalle anliegenden Fangpotentialen und

Fig. 3     eine Darstellung des Potentialverlaufes bei der Anordnung nach Fig. 1 sowie der Ionenkonzentration bei fehlenden Fangpotentialen.

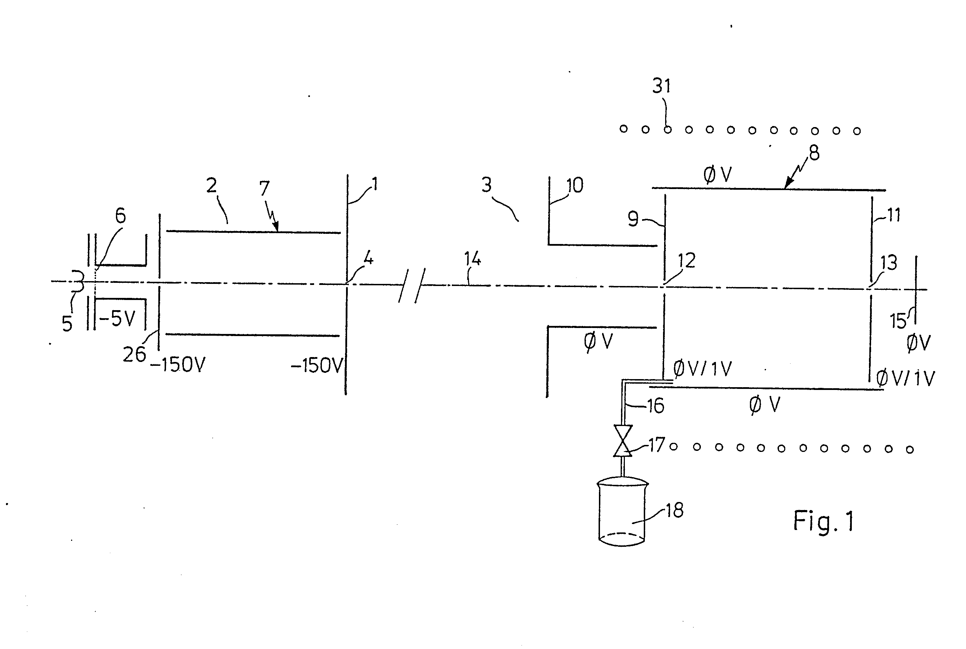

Das in Fig. 1 schematisch dargestellte Ionen-Zyklotron-Resonanz-Spektrometer umfaßt zwei durch eine Lochblende 1 getrennte Kammern, nämlich eine Einlaßkammer 2 und eine Meßkammer 3. Das in der Blende 1 vorhandene, sehr kleine Loch 4, dessen Durchmesser bei einer praktischen Ausführungsform der Erfindung 0,5 mm beträgt, erlaubt es, in den beiden Kammern 2 und 3 unterschiedliche Drücke aufrechtzuerhalten. Während in der Einlaßkammer 2 ein für die Ionenerzeugung günstiger Druck von etwa $10^{-4}$Pa erzeugt wird, wird in der Meßkammer 3 ein Ultra-Hoch-Vakuum von etwa $10^{-7}$Pa aufrechterhalten, das Zyklotron-Resonanz-Messungen mit der sehr hohen Auflösung von etwa 1 Hz ermöglicht. In der Einlaßkammer 2 befindet sich eine Ionenquelle, die eine Glühkathode 5 und eine Beschleunigungselektrode 6 zur Erzeugung eines Elektronenstrahles umfaßt. Die durch den Beschuß mit einem Elektronenstrahl erzeugten Ionen werden mittels einer Beschleunigungselektrode 26 beschleunigt und auf das Loch 4 in der Blende 1 gerichtet. Eine von vier Elektroden in Quadrupolanordnung gebildete Zusatzelektrode erlaubt das Ausblenden einzelner Ionensorten oder des ganzen Ionenstrahles.

In der Meßkammer 3 befindet sich die eigentliche Meßzelle 8, deren leitende und auf Fangpotentialen gehaltenen Platten eine Ionenfalle bilden. Vor der der Blende 1 zugewandten vorderen Fangplatte 9 befindet sich eine Schirmelektrode 10. Sowohl die vordere Fangplatte 9 als auch die hintere Fangplatte 11 weisen eine zentrale Bohrung 12 bzw. 13 auf. Diese zentralen Bohrungen 12 und 13 liegen zusammen mit dem Loch 4 der Blende 1 auf einer gemeinsamen Achse 14, die zugleich die Achse des Ionenstrahles bildet. In Richtung des Ionenstrahles hinter der Meßzelle 8 befindet sich eine Anode 15, die in nicht näher dargestellter Weise mit einem Elektrometer verbunden ist, welches ein Optimieren des Ionenstromes und eine Messung der in der Zelle gefangenen Ionenladung ermöglicht. Die Meßzelle 8 ist weiterhin mit einem Einlaß für eine Leitung 16 versehen, die mittels eines Ventiles 17 absperrbar ist und das Zuführen von Gas aus einem Behälter 18 in die Meßzelle 8 gestattet, und ist einem homogenen Magnetfeld ausgesetzt, das sich in Richtung der Achse 14 erstreckt. Dieses Magnetfeld kann beispielsweise durch eine die Meßzelle 8 umgebende Magentspule 31, insbesondere einen Kryomagneten, erzeugt werden.

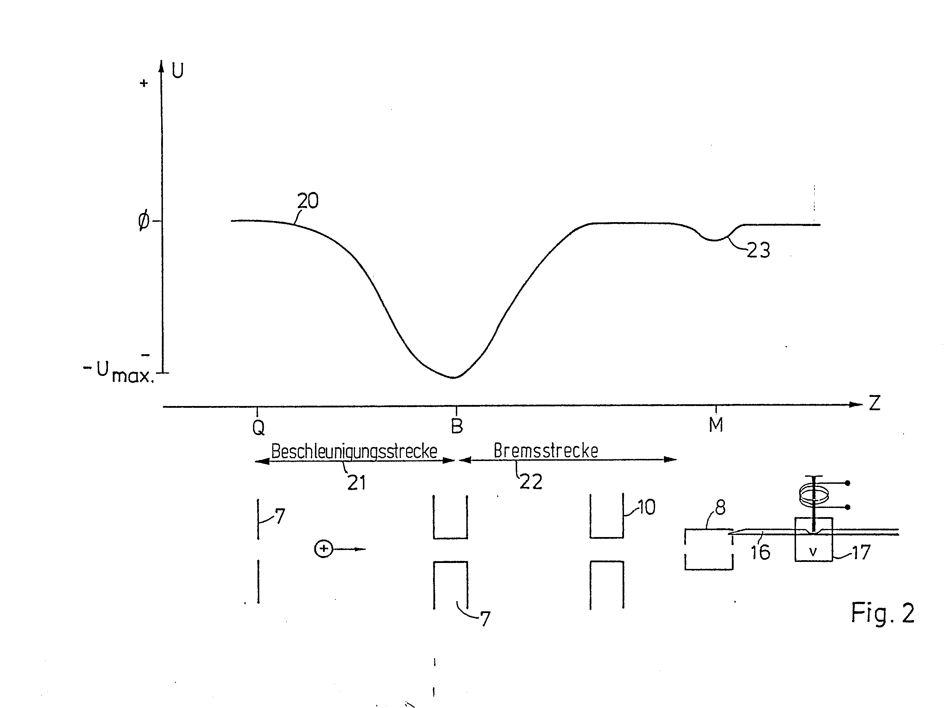

Wie Fig. 2 zeigt, ergibt sich längs der anhand Fig. 1 beschriebenen und in Fig. 2 nochmals stark vereinfacht dargestellten Anordnung ein durch die Kurve 20 wiedergegebener Potentialverlauf, der bei der Ionenquelle 7 im Punkt Q beim Potential 0 beginnt, ein maximales negatives Potential $-U_{max}$ am Ende der Beschleunigungsstrecke 21 am Ort B der Blende erreicht und dann wieder längs der Bremsstrecke 22 bis zum Wert 0 am Eingang der Meßzelle 8 ansteigt. Im Bereich der Meßzelle entsteht infolge der an die Meßzelle angelegten Fangpotentiale ein Potentialtopf 21, in dem normalerweise innerhalb der Meßzelle erzeugte oder nach der Erfindung eingeführte Ionen gefangen sind.

Wie Fig. 2 ohne weiteres erkennen läßt, gibt es keinen offensichtlichen Weg, um außerhalb der Meßzelle erzeugte Ionen in Form eines Ionenstrahles der Meßzelle zuzuführen und darin zu fangen. Um in die Ionenfalle zu gelangen, müssen die Ionen unabhängig von der Größe der die Ionenfalle begrenzenden Potentiale genügend Energie aufweisen, um den ersten Potentialwall des Potentialtopfes zu überwinden. Wenn aber ein Ion genügend Energie aufweist, um den ersten Potentialwall zu überwinden, hat es auch die nötige Energie, um die Zelle direkt oder nach Reflexion am zweiten Wall wieder zu verlassen, weil die freie Weglänge der Ionen bei dem innerhalb der Meßkammer herrschenden geringen Druck sehr viel größer ist als die Abmessungen der Ionenfalle, so daß innerhalb der Ionenfalle kein Energieverlust eintreten kann, der die kinetische Energie der Ionen unter das Maß bringen könnte, das zum Überwinden der Potentialwälle erforderlich wäre.

Die als Ausführungsbeispiel dargestellte Ausführungsform eines Ionen-Zyklotron-Resonanz-Spektrometers erlaubt es jedoch, durch Öffnen des Ventils 17 aus dem Behälter 18 über die Leitung 16 in die Meßzelle 8 so viel Gas einzuführen, daß der Druck innerhalb der Meßzelle auf Werte ansteigt, bei denen die freie Weglänge der Ionen geringer ist als die Abmessungen der Zelle. Infolgedessen verlieren die in die Meßzelle 8 eingedrungenen Ionen an kinetischer Energie mit dem Ergebnis, daß sie in der Meßzelle gefangen werden. Wenn auf diese Weise eine ausreichende Anzahl von Ionen in die Ionenfalle eingebracht und darin gefangen worden ist, kann der Druck durch Abpumpen wieder auf den erforderlichen Betrag gesenkt werden, wobei aus der Meßzelle nur neutrale Moleküle, nicht aber die darin befindlichen Ionen abgepumpt werden können. Es ist daher auf diese Weise möglich, die Meßzelle mit einer großen Anzahl Ionen zu füllen und dementsprechend bei der Ionen-Zyklotron-Resonanz-Spektrometrie Signale großer Amplitude zu erhalten.

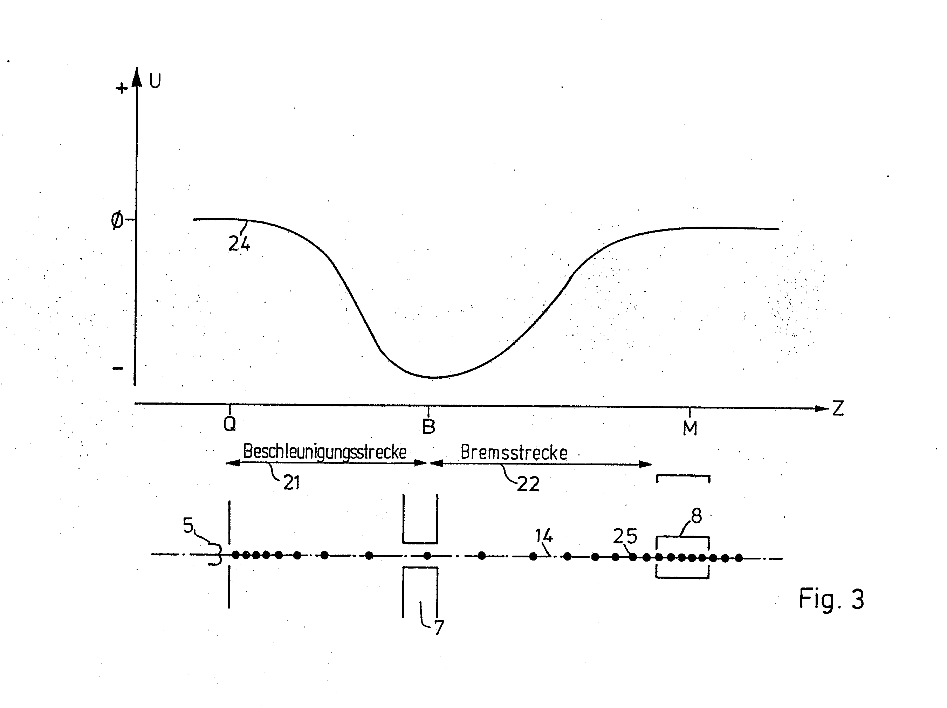

Wie Fig. 3 veranschaulicht, besteht aber auch die Möglichkeit, die Fangpotentiale an der Ionenfalle 8 vorübergehend abzuschalten, so daß der in Fig. 3 durch die Kurve 24 wiedergegebene Potentialverlauf entsteht, bei dem ein Potentialtopf im Bereich der Ionenfalle 8 fehlt. Die Potentiale für die Beschleunigungsstrecke und die Bremsstrecke sind dann so zu wählen, daß die Ionen theoretisch im Mittelpunkt der Zelle 8 zum Stillstand kommen, woraus sich die in Fig. 3 durch die Dichte der auf der Achse 14 angegebenen Punkte 25 schematisch dargestellte Ionenverteilung ergibt. Obwohl die Ionen neben der kontrollierbaren, aufgezwungenen kinetischen Energie auch thermische Energie besitzen, welche Restgeschwindigkeiten mit stochastischer Verteilung zur Folge hat, ergibt sich das in Fig. 3 wiedergegebene Momentanbild für die Ionenkonzentration, die im Bereich der Mitte der Zelle 8 relativ hoch ist. Wird bei einem solchen Zustand der Ionenverteilung das Fangpotential an die Meßzelle angelegt, so werden die im Augenblick des Anlegens innerhalb der Zelle vorhandenen Ionen eingefangen und stehen für eine nachfolgende Messung des Spektrums zur Verfügung.

Die erfindungsgemäße Ausbildung des Ionen-Zyklotron-Resonanz-Spektrometers hat nicht nur den Vorteil, daß sie durch Einführen eines Ionenstrahles in die Meßzelle das Einbringen von Ionen der Probensubstanz mit hoher Konzentration ermöglicht, ohne daß hierzu komplizierte oder den Meßvorgang stark verzögernde Maßnahmen erforderlich wären, sondern es wird auch noch der besondere Vorteil erzielt, daß die eingefangenen Ionen in jedem Falle Ionen mit geringer thermischer Energie sind, die für Zyklotron-Resonanz-Experimente besonders günstig sind. Insgesamt erlaubt die erfindungsgemäße Ausbildung des ICR-Spektrometers die Eliminierung aller eingangs erwähnten Schwierigkeiten. Dabei ist die erwünschte Vorselektion der Ionen nicht nur durch geeignete Wahl der Potentiale an den Zusatzelektroden 7 möglich, sondern es besteht beim Betrieb gemäß Fig. 3 zudem die Möglichkeit, die unterschiedliche Laufzeit von schweren und leichten Ionen auszunützen und durch zeitlich geeignetes Schalten der Potentiale interessierende Ionen für den Einfang auszuwählen.

Patentansprüche

1. Ionen-Zyklotron-Resonanz-Spektrometer mit einer Ionenfalle, die als Elektroden ausgebildete Wände aufweist,
an denen die Ionen in der Falle haltende elektrische
Fangpotentiale anliegen, und in der ein homogenes,
konstantes Magnetfeld herrscht, und mit einer Einrichtung zum Einbringen von Ionen in die Ionenfalle, die
eine Ionenquelle und Mittel zum Erzeugen und Führen
eines von der Ionenquelle ausgehenden Ionenstrahles
umfaßt,

dadurch gekennzeichnet,

daß die Mittel zum Führen des Ionenstrahles in Richtung des Magnetfeldes ausgebildet sind und auf dem
Weg (14) des Ionenstrahles eine Einrichtung zum Reduzieren der kinetischen Energie von in die Ionenfalle
eindringenden Ionen bis unter den durch die Fangpotentiale bestimmten Wert angeordnet ist, der zum Verlassen der Ionenfalle erforderlich wäre.

2. Ionen-Zyklotron-Resonanz-Spektrometer nach Anspruch 1,
dadurch gekennzeichnet, daß die Einrichtung zum Reduzieren der kinetischen Energie Mittel (16, 17, 18) zum
vorübergehenden Erhöhen und Wiederabsenken des Gasdruckes in der Ionenfalle (8) umfaßt.

3. Ionen-Zyklotron-Resonanz-Spektrometer nach Anspruch 1 dadurch gekennzeichnet, daß die Einrichtung zum Reduzieren der kinetischen Energie wenigstens eine der Ionenfalle (8) vorgeschaltete Bremselektrode (10), die bewirkt, daß die Ionen bei fehlenden Fangpotentialen gerade die Mitte der Ionenfalle (8) erreichen, und eine Einrichtung zum vorübergehenden Aufheben der Fangpotentiale umfaßt.

4. Ionen-Zyklotron-Resonanz-Spektrometer nach Anspruch 3, dadurch gekennzeichnet, daß die Einrichtung zum Aufheben der Fangpotentiale mit einem Zeitgeber gekoppelt ist, der es erlaubt, die Fangpotentiale in einem Zeitpunkt einzuschalten, in dem sich aufgrund ihrer Flugzeit gerade eine ausgewählte Kategorie interessierender Ionen in der Zelle befindet.

Fig. 1

Fig. 2

Fig. 3

0200027